# EUROPEAN PATENT APPLICATION

(11) **EP 2 642 836 A2**
(43) Date of publication of application: **25.09.2013**
(21) Application number: 12173733.2
(22) Date of filing: 27.06.2012
(51) Int. Cl.: H05K 1/02

(54) **Wiring board device, luminaire and manufacturing method of the wiring board device**

(30) Priority: 23.03.2012 JP 2012068332
(71) Applicant: Toshiba Lighting & Technology Corporation, Yokosuka-shi Kanagawa 237-8510 (JP)
(72) Inventor: Betsuda, Nobuhiko, Kanagawa, 237-8510 (JP); Tanaka, Hirotaka, Kanagawa, 237-8510 (JP); Honma, Takuya, Kanagawa, 237-8510 (JP); Watanabe, Miho, Kanagawa, 237-8510 (JP); Nishimura, Kiyoshi, Kanagawa, 237-8510 (JP)
(74) Representative: Bokinge, Ole

(57) **Abstract**

According to one embodiment, a wiring board device includes a ceramic board including a first surface and a second surface. A first electrode layer is formed on the first surface of the ceramic board, and a second electrode layer is formed on the second surface of the ceramic board. The first electrode layer and the second electrode layer are not electrically connected to each other. A first copper plated layer as a wiring pattern is formed on the first electrode layer, and a second copper plated layer is formed on the second electrode layer. The first copper plated layer and the second copper plated layer are not electrically connected to each other. A heat spreader is thermally connected to the second copper plated layer.

## Description

### FIELD

Embodiments described herein relate generally to a wiring board device including a wiring pattern, a luminaire and a manufacturing method of the wiring board device.

### BACKGROUND

Hitherto, for example, in an LED module used in a luminaire, a wiring board device in which a wiring pattern is formed on one surface of a board is used. An LED element is electrically connected to the wiring pattern of the wiring board device. Lighting power from a lighting device is supplied to the LED element through the wiring pattern, and the LED element is turned on.

Besides, in the LED module, the output thereof is increased, and the board is required to have high heat resistance and high heat radiation property as the output increases. In order to satisfy this request, a ceramic board is often used. Also in the ceramic board, similarly to a general printed wiring board, a wiring pattern is generally formed on one surface of the ceramic board by printing.

In order to increase the output of the LED module, a large current is made to flow to the LED element through the wiring pattern, and the amount of heat generated in the LED element is increased since the large current is made to flow. Accordingly, a high heat radiation property is required to be secured.

However, in the related art wiring board device, although the ceramic board is used, since the wiring pattern on the ceramic board is formed by printing, it is difficult to cause a large current to flow through the wiring pattern. This is because, since the thickness of the wiring pattern formed by printing is thin and the cross section through which current flows is small, when a large current is made to flow through the wiring pattern, the wiring pattern is melted by Joule heat and is broken. Besides, although the width of the wiring pattern is widened and the cross section through which current flows can be increased, unless the width of the wiring pattern is widened very widely, the wiring pattern can not resist a large current. Thus, the ceramic board must be made large.

Further, even if a large current can be made to flow through the wiring pattern, since the amount of heat generation of the LED element increases, a required heat radiation property can not be obtained, and consequently, it becomes difficult to cause a large current to flow through the LED element.

As stated above, it is required that the wiring board device can allow a large current to flow through the wiring pattern in a limited size of the ceramic board, and can secure a high heat radiation property.

Exemplary embodiments described herein provide a wiring board device, a luminaire and a manufacturing method of the wiring board device, in which a large current can be made to flow through a wiring pattern in a limited size of a ceramic board, and a high heat radiation property can be secured.

### BRIEF DESCRIPTION OF THE DRAWINGS

FIG. 1 is a sectional view of a wiring board device of an embodiment.
FIG. 2 is an enlarged sectional view of a part of the wiring board device.
FIG. 3 is an explanatory view of a first copper plated layer (wiring pattern) of the wiring board device.
FIG. 4 is a front view of the wiring board device.
FIGS. 5(a) to 5(f) are sectional views showing a manufacturing method of the wiring board device.
FIGS. 6(a) and 6(b) show wiring patterns according to different manufacturing methods, in which FIG. 6(a) is a sectional view of a wiring pattern formed by copper plating, and FIG. 6(b) is a sectional view of a wiring pattern formed by etching.
FIG. 7 is a perspective view of a luminaire using the wiring board device.

### DETAILED DESCRIPTION

In general, according to one embodiment, a wiring board device includes a ceramic board including a first surface and a second surface. A first electrode layer is formed on the first surface of the ceramic board, and a second electrode layer is formed on the second surface of the ceramic board. The first electrode layer and the second electrode layer are not electrically connected to each other. A first copper plated layer as a wiring pattern is formed on the first electrode layer, and a second copper plated layer is formed on the second electrode layer. The first copper plated layer and the second copper plated layer are not electrically connected to each other. A heat spreader is thermally connected to the second copper plated layer.

According to this structure, since the wiring pattern is formed of the first copper plated layer on the first surface side of the ceramic board, the thickness of the wiring pattern can be easily increased. Further, the second copper plated layer is formed on the second surface side of the ceramic board, and the heat spreader is thermally connected to the second copper plated layer. Accordingly, heat is efficiently conduced from the ceramic board to the heat spreader and can be radiated. Accordingly, a large current can be made to flow through the wiring pattern in the limited size of the ceramic board, and a high heat radiation property can be secured.

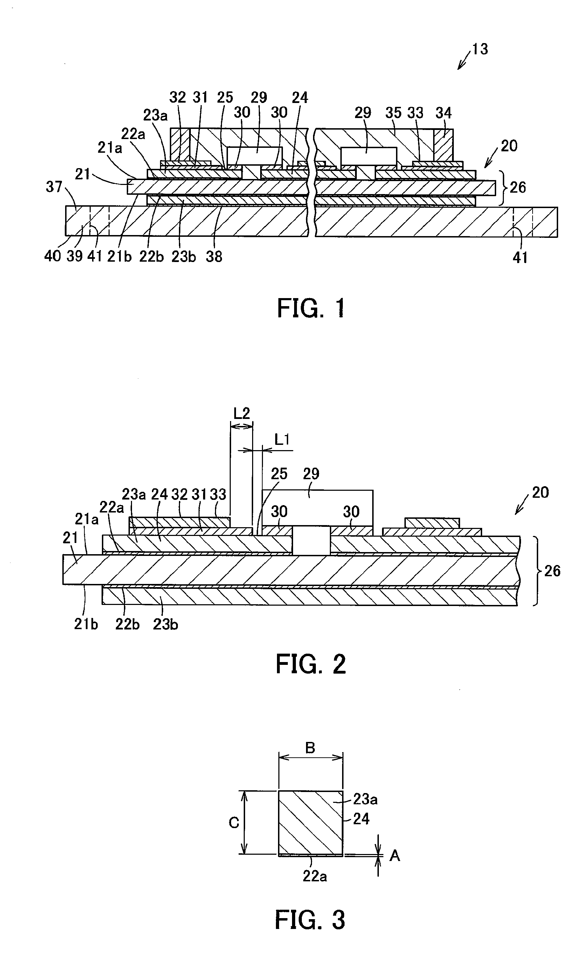

Hereinafter, embodiments will be described with reference to FIG. 1 to FIG. 7.

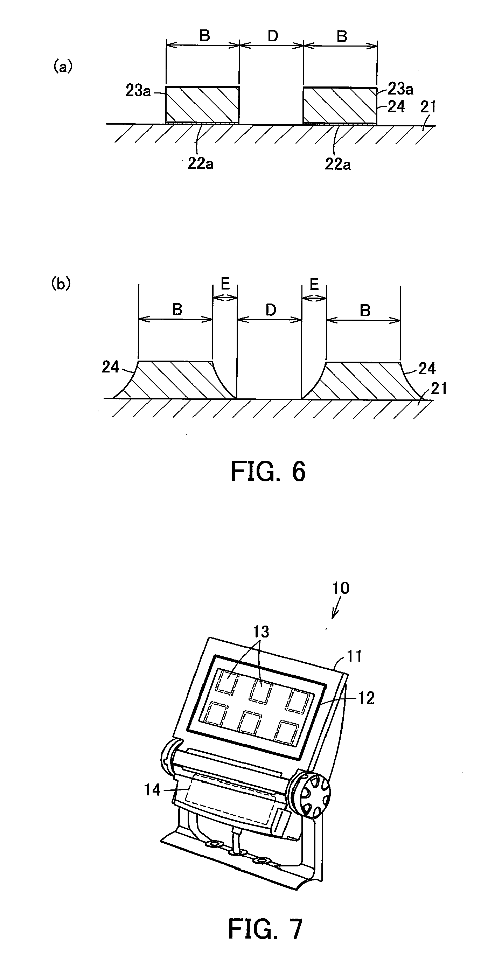

FIG. 7 shows a luminaire 10. The luminaire 10 is, for example, a floodlight used for lighting-up. The luminaire 10 includes an equipment main body 11, and a floodlight window 12 is provided in the equipment main body 11. Plural light-emitting modules 13 facing the floodlight window 12 are housed in the equipment main body 11. A lighting device 14 to supply lighting power to the light-emitting modules 13 is housed at a lower part in the equipment main body 11. The lighting device 14 supplies the lighting power to the plural light-emitting modules 13, so that the plural light-emitting modules 13 are turned on, and light is emitted from the floodlight window 12.

FIG. 1 to FIG. 4 show the light-emitting module 13. The light-emitting module 13 includes a wiring board device 20.

The wiring board device 20 includes a square ceramic board 21. A front side of the ceramic board 21 is a first surface 21a, and a back side thereof is a second surface 21b. A first electrode layer 22a is formed on the first surface 21a, and a first copper plated layer 23a is formed on the first electrode layer 22a. A wiring pattern 24 having a specific shape is formed of the first electrode layer 22a and the first copper plated layer 23a. On the other hand, a second electrode layer 22b is formed on substantially the whole area of the second surface 21b, and a second copper plated layer 23b is formed on the second electrode layer 22b. Further, metal plated layers 25 to protect the copper plated layers 23a and 23b are formed on the surfaces of the copper plated layers 23a and 23b.

The electrode layers 22a and 22b are formed by sputtering of a metal such as titanium. The copper plated layers 23a and 23b are formed by copper plating, and the metal plated layers 25 are formed of, for example, nickel/gold plating or nickel/lead/ gold plating. A DPC (Direct Plated Copper) board 26 is formed of the ceramic board 21, the electrode layers 22a and 22b, the copper plated layers 23a and 23b, and the metal plated layers 25.

The first electrode layer 22a and the second electrode layer 22b are formed to have the same thickness, and the first copper plated layer 23a and the second copper plated layer 23b are formed to have the same thickness. As shown in FIG. 3, the thickness A of the first electrode layer 22a is about 1 µm, the minimum width B of the first copper plated layer 23a (the wiring pattern 24 through which current flows) is 50 to 75 µm, and the thickness C thereof is 35 to 100 µm (preferably, 50 to 75 µm). Incidentally, if the wiring pattern is formed by printing, the thickness of the wiring pattern is at most about 10 µm.

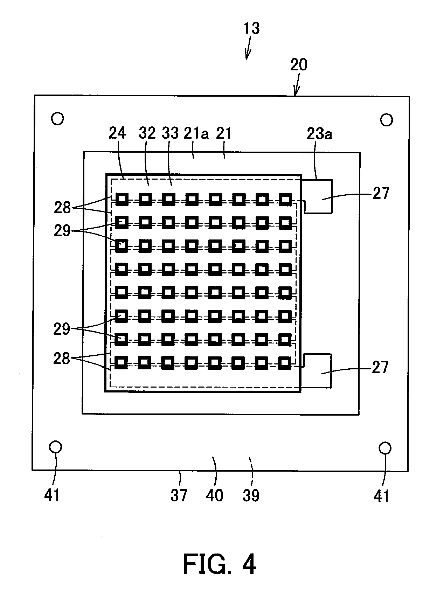

As shown in FIG. 4, the wiring pattern 24 includes a pair of electrode parts 27 to receive lighting power from the outside, and plural wiring parts 28 are formed in parallel between the pair of electrode parts 27. Plural LED elements 29 are mounted on the adjacent wiring parts 28.

As shown in FIG. 1, the plural LED elements 29 are of a type, such as a flip chip type, in which a pair of electrodes are provided on the back side. The pairs of electrodes of the plural LED elements 29 are electrically connected to the first copper plated layer 23a by solder die bond layers 30. Incidentally, the LED element may be such that an electrode is provided on the front surface side as in a face-up type, and the electrode of the LED element and the wiring pattern 24 are connected by wire bonding.

As shown in FIG. 2, an organic resist layer 31 is formed on the first surface 21a side including the first copper plated layer 23a, and the organic resist layer is spaced from the plural LED elements 29 by a first distance L1. An inorganic resist ink layer 32 is formed on the organic resist layer 31, and the inorganic resist ink layer is spaced from an end of the organic resist layer 31 facing the plural LED elements 29 by a second distance L2. The surfaces of the organic resist layer 31 and the inorganic resist ink layer 32 are formed as a reflecting surface 33 to reflect light emitted from the plural LED elements 29.

Although the organic resist layer 31 contains epoxy resin as a main component and is white, there is a tendency that the color is liable to change. The inorganic resist ink layer 32 contains ceramic as a main component and is white, and has a characteristic that the color is hard to change. However, since the particle diameter of the ceramic is large, there is a tendency that light is liable to pass through. Thus, a two-layer structure is adopted in which the inorganic resist ink layer 32 is formed on the organic resist layer 31, so that high reflection efficiency can be continuously maintained.

Although the organic resist layer 31 can be patterned and formed by using a photoresist, the inorganic resist ink layer 32 is patterned and formed by printing. The patterning size accuracy of the inorganic resist ink layer 32 patterned and formed by printing is low, and the distance between itself and the LED element 29 is not stable. Thus, the second distance L2 is increased in view of the size accuracy. When the second distance L2 is large, an area which does not contribute to light reflection becomes large, and reflection efficiency is reduced. Then, the organic resist layer 31 with high patterning accuracy is formed to be close to the LED element 29, so that high reflection efficiency can be obtained. The first distance L1 is 25 to 200 µm, the second distance L2 is 50 to 200 µm, and the relation of the first distance L1 ≤ the second distance L2 is established.

Besides, an annular reflecting frame 34 is formed on the first surface 21a side so as to surround a mount area of the plural LED elements 29. A sealing resin 35 to seal the plural LED elements 29 is filled inside the reflecting frame 34. The sealing resin 35 contains a phosphor which is excited by the light generated by the plural LED elements 29. For example, if the light-emitting module 13 emits white light, the LED element 29 emitting blue light and the phosphor mainly emitting yellow light are used. The blue light generated by the LED element 29 is mixed with the yellow light generated by the phosphor which is excited by the blue light generated by the LED element 29, and the white light is emitted from the surface of the sealing resin 35. Incidentally, the LED element 29 and the phosphor, which emit lights of colors corresponding to the color of irradiated light, are used.

Besides, a heat spreader 37 is fixed to the second copper plated layer 23b through a solder layer 38 and is thermally connected thereto. The heat spreader 37 includes a copper plate 39 having a thickness of 0.1 to 3 mm, and a metal plated layer 40 such as a nickel plated layer is formed on the whole surface of the copper plate 39. Attachment holes 41 for fixing to a heat radiation part of the luminaire 10 using screws are formed at four corners of the heat spreader 37.

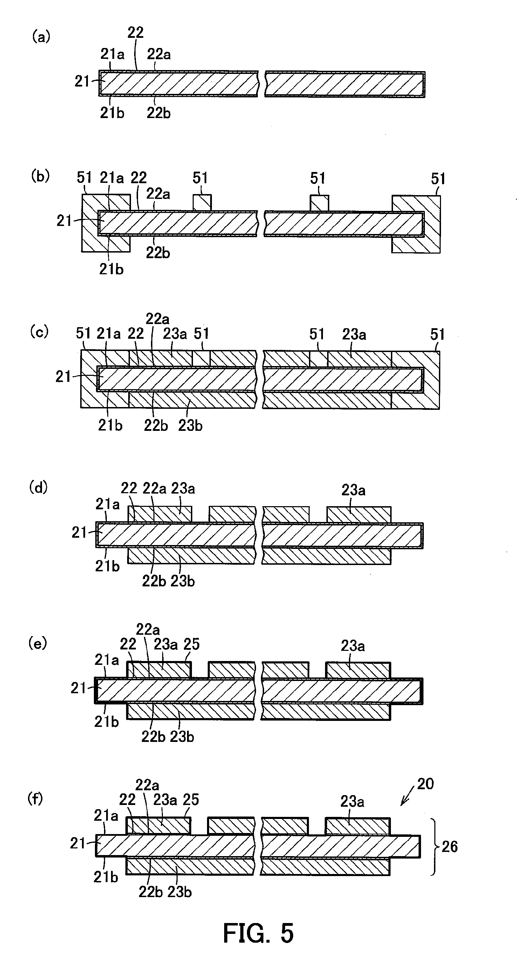

Next, a manufacturing method of the DPC board 26 of the wiring board device 20 will be described with reference to FIGS. 5(a) to 5(f).

As shown in FIG. 5(a), a metal such as titanium is sputtered on the whole surface of the ceramic board 21, and an electrode layer 22 including the first electrode layer 22a and the second electrode layer 22b is formed.

As shown in FIG. 5 (b), a resist 51 is patterned and formed on the electrode layer 22.

As shown in FIG. 5 (c), the ceramic board 21 is immersed in a copper plating solution of a plating apparatus, and electrical power is applied to the electrode layer 22, so that electrolytic plating is performed on the electrode layer 22 exposed from the resist 51, and the first copper plated layer 23a and the second copper plated layer 23b having a specific thickness are simultaneously formed. At this time, since the first copper plated layer 23a and the second copper plated layer 23b are simultaneously formed, the first copper plated layer 23a and the second copper plated layer 23b have the same thickness. After the electrolytic plating is completed, the ceramic board 21 is taken out from the plating apparatus.

As shown in FIG. 5 (d), only the resist 51 is removed from the ceramic board 21 by etching.

As shown in FIG. 5 (e), the metal plated layer 25 is formed on the surfaces of the copper plated layers 23a and 23b. That is, the ceramic board 21 is immersed in a metal plating solution of the plating apparatus, and electrical power is applied to the electrode layer 22, so that electrolytic plating is performed on the copper plated layers 23a and 23b and the electrode layer 22, and the metal plated layer 25 is formed. After the electrolytic plating is completed, the ceramic board 21 is taken out from the plating apparatus.

As shown in FIG. 5 (f), a portion of the electrode layer 22 in which the copper plated layers 23a and 23b are not laminated is removed from the ceramic board 21 by etching.

In this way, the DPC board 26 of the wiring board device 20 is manufactured.

Besides, when the light-emitting module 13 is manufactured by using the DPC board 26 of the wiring board device 20, as shown in FIG. 1 and FIG. 2, the organic resist layer 31 is patterned and formed on the first surface 21a side including the first copper plated layer 23a by using a photoresist. Further, the inorganic resist ink layer 32 is patterned and formed on the organic resist layer 31 by printing.

The plural LED elements 29 are electrically connected to the wiring pattern 24 (the first copper plated layer 23a) by the solder die bond layer 30.

The annular reflecting frame 34 is provided so as to surround the mount area of the plural LED elements 29, and the sealing resin 35 to seal the plural LED elements 29 is filled inside the reflecting frame 34.

Besides, the heat spreader 37 is fixed to the second copper plated layer 23b by the solder layer 38 and is thermally connected thereto.

In this way, the light-emitting module 13 is manufactured.

Besides, as shown in FIG. 7, the plural light-emitting modules 13 are disposed in the equipment main body 11. In this case, screws are threaded into the attachment holes 41 of the heat spreader 37 to fix the heat spreader to the heat radiation part of the equipment main body 11, and the heat spreader 37 is thermally connected to the heat radiation part of the equipment main body 11. Besides, the pair of electrode parts 27 of the wiring pattern 24 are electrically connected to the lighting device 14 by electric wires.

The lighting device 14 supplies lighting power to the plural light-emitting modules 13, so that the lighting power flows through the plural LED elements 29 through the wiring patterns 24 of the respective light-emitting modules 13. Thus, the plural light-emitting modules 13 are turned on, and the lights from the plural light-emitting modules 13 are emitted from the floodlight window 12.

The heat generated in the plural LED elements 29 at the time of lighting of the light-emitting modules 13 is efficiently conducted to the first copper plated layer 23a, the ceramic board 21, the second copper plated layer 23b and the heat spreader 37. Further, the heat is efficiently conducted from the heat spreader 37 to the heat radiation part of the equipment main body 11, and is radiated from the heat radiation part of the equipment main body 11.

In this embodiment, since the wiring pattern 24 is formed of the copper plated layer 23a on the first surface 21a side of the ceramic board 21, the thickness of the wiring pattern 24 can be easily increased. Thus, a large current can be made to flow through the wiring pattern 24, and high output of the light-emitting module 13 can be ensured.

Further, since the second copper plated layer 23b is formed on the second surface 21b side of the ceramic board 21, the high heat radiation property from the second copper plated layer 23b can be obtained.

Accordingly, a large current can be made to flow through the wiring pattern 24 in the limited size of the ceramic board 21, and the high heat radiation property can be secured.

Besides, the first copper plated layer 23a and the second copper plated layer 23b have the same thickness. That is, the first copper plated layer 23a and the second copper plated layer 23b can be simultaneously formed at the time of plating, and the manufacturing efficiency can be improved.

Besides, since the first electrode layer 22a and the first copper plated layer 23a are not electrically connected to the second electrode layer 22b and the second copper plated layer 23b, the reliability can be secured.

Besides, since the minimum width of the first copper plated layer 23a (the wiring pattern 24 through which current flows) is 50 to 75 µm, and the thickness is 35 to 100 µm, a large current can be made to flow without increasing the width. Incidentally, the thickness of the first copper plated layer 23a is preferably 50 µm or more from the viewpoint that a large current is made to flow and is 75 µm or less from the viewpoint of manufacturing efficiency. That is, the more preferable thickness range of the first copper plated layer 23a is 50 to 75 µm.

Besides, a current of 1 to 8 amperes flows through the first copper plated layer 23a, and even if a current is large as a current flowing through the wiring pattern 24, the large current can be allowed to flow through the first copper plated layer 23a.

Besides, further merits obtained when the wiring pattern 24 is formed by copper plating will be described with reference to FIGS. 6(a) and 6(b). FIG. 6(a) shows the embodiment in which the wiring pattern 24 is formed by copper plating, and FIG. 6(b) shows a comparative example in which the wiring pattern 24 is formed by etching. In both cases, the width of the wiring pattern 24 is B, and the interval between the adjacent wiring patterns 24 is D.

As shown in FIG. 6(b), in the comparative example in which the wiring pattern 24 is formed by etching, since inclined portions are formed on both sides of the wiring pattern 24, the pitch of the wiring pattern 24 becomes wide by width E of the inclined portion on both sides, and the size becomes large.

On the other hand, as shown in FIG. 6(a), in the embodiment in which the wiring pattern 24 is formed by copper plating, since the resist 51 for patterning the wiring pattern 24 (the first copper plated layer 23a) can be removed by etching, an inclined portion is not formed on the side of the wiring pattern 24, the pitch of the wiring pattern 24 can be shortened, and the size can be reduced.

Besides, since the heat spreader 37 is thermally connected to the second copper plated layer 23b, heat is efficiently conducted from the ceramic board 21 to the heat spreader 37 and can be radiated, and high output of the light-emitting module 13 can be ensured.

Further, since the second copper plated layer 23b and the heat spreader 37 are soldered to each other, heat conductivity from the second copper plated layer 23b to the heat spreader 37 can be improved.

Besides, the plural LED elements 29 are electrically connected to the first copper plated layer 23a of the wiring board device 20, so that the light-emitting module 13 capable of ensuring high output can be provided.

Besides, since the organic resist layer 31 is formed on the first copper plated layer 23a and the inorganic resist ink layer 32 is formed on the organic resist layer 31, high reflection efficiency can be continuously maintained. That is, although the organic resist layer 31 contains epoxy resin as a main component and is white, there is a tendency that the color is liable to change. On the other hand, the inorganic resist ink layer 32 contains ceramic as a main component and is white, and has a characteristic that the color is hard to change. However, since the particle diameter of the ceramic is large, there is a tendency that light is liable to pass through. Thus, the two-layer structure is adopted in which the inorganic resist ink layer 32 is formed on the organic resist layer 31, so that high reflection efficiency can be continuously maintained.

Besides, the organic resist layer 31 is formed to be spaced from the LED element 29 by the first distance L1, the inorganic resist ink layer 32 is formed to be spaced from the end of the organic resist layer 31 facing the LED element 29 by the second distance L2, and the relation of the first distance L1 ≤ second distance L2 is established. Thus, high reflection efficiency can be obtained. That is, although the organic resist layer 31 can be patterned and formed by using a photoresist, the inorganic resist ink layer 32 is patterned and formed by printing. The patterning accuracy of the inorganic resist ink layer 32 patterned and formed by printing is low, and the distance between itself and the LED element 29 is not stable. Thus, the second distance L2 is preferably increased in view of the accuracy. When the second distance L2 is large, an area which does not contribute to the light reflection becomes large, and reflection efficiency is reduced. Then, the organic resist layer 31 with high patterning accuracy is formed to be close to the LED element 29, so that high reflection efficiency can be obtained. The first distance L1 is 25 to 200 µm, the second distance L2 is 50 to 200 µm, and the respective distances L1 and L2 can be suitably set according to the foregoing condition.

Besides, since the metal plated layer 25 is formed on the first copper plated layer 23a between the LED element 29 and the organic resist layer 31, the first copper plated layer 23a is prevented from being corroded and can be protected.

Incidentally, the wiring board device 20 is not limited to the wiring board device for mounting the LED elements 29, and the wiring board device 20 can also be applied to a wiring board device for mounting an integrated circuit, or a wiring board device for mounting electrical parts of a power supply device.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. A wiring board device (20) comprising:
a ceramic board (21) including a first surface (21a) and a second surface (21b);
a first electrode layer (22a) provided on the first surface (21a);
a second electrode layer (22b) that is not electrically connected to the first electrode layer (22a) and is provided on the second surface (21b);
a first copper plated layer (23a) as a wiring pattern (24) provided on the first electrode layer (22a);
a second copper plated layer (23b) that is not electrically connected to the first copper plated layer (23a) and is provided on the second electrode layer (22b); and
a heat spreader (37) thermally connected to the second copper plated layer (23b).

2. The device (20) of claim 1, wherein a thickness of the first copper plated layer (23a) is equal to a thickness of the second copper plated layer (23b).

3. The device (20) of claim 1 or 2, wherein a minimum width of the first copper plated layer (23a) is 50 to 75 µm, and a thickness is 35 to 100 µm.

4. The device (20) of any one of claims 1 to 3, wherein a current of 1 to 8 amperes flows through the first copper plated layer (23a).

5. The device (20) of any one of claims 1 to 4, further comprising an LED element (29) electrically connected to the first copper plated layer (23a) of the wiring board device (20).

6. The device (20) of claim 5, wherein an organic resist layer (31) is provided on the first copper plated layer (23a) and an inorganic resist ink layer (32) is provided on the organic resist layer (31).

7. The device (20) of claim 6, wherein
the organic resist layer (31) is provided to be spaced from the LED element (29) by a first distance (L1), and
the inorganic resist ink layer (32) is provided to be spaced from the organic resist layer (31) by a second distance (L2).

8. The device (20) of claim 7, wherein the first distance (L1) is 25 to 200 µm, and the second distance (L2) is 50 to 200 µm.

9. The device (20) of claim 7 or 8, wherein a metal plated layer (25) is provided on the first copper plated layer (23a) between the LED element (29) and the organic resist layer (31).

10. A luminaire (10) comprising:
an equipment main body (11); and
a wiring board device (20) of any one of claims 5 to 9 disposed on the equipment main body (11).

11. A manufacturing method of a wiring board device (20), comprising:
forming a first electrode layer (22a) and a second electrode layer (22b) on a first surface (21a) and a second surface (21b) of a ceramic board (21) by integrally forming an electrode layer (22) on a whole surface of the ceramic board (21) ;
forming a resist (51) on the first electrode layer (22a) and the second electrode layer (22b);
forming a first copper plated layer (23a) on the first electrode layer (22a) by plating and forming a second copper plated layer (23b) on the second electrode layer (22b);
removing the resist (51) on the first electrode layer (22a) and the second electrode layer (22b);
electrically insulating the first electrode layer (22a) and the second electrode layer (22b); and
thermally connecting a heat spreader (37) to the second copper plated layer (23b).

12. The method of claim 11, wherein the first copper plated layer (23a) and the second copper plated layer (23b) are simultaneously formed by the plating, and the first copper plated layer (23a) and the second copper plated layer (23b) having a same thickness are formed.

13. The method of claim 11 or 12, wherein the first copper plated layer (23a) is formed to have a minimum width of 50 to 75 µm and a thickness of 35 to 100 µm.

14. The method of any one of claims 11 to 13, further comprising electrically connecting an LED element (29) to the first copper plated layer (23a).

15. The method of any one of claims 11 to 14, wherein an organic resist layer (31) is formed on the first copper plated layer (23a), and an inorganic resist ink layer (32) is formed on the organic resist layer (31).
